# EUROPEAN PATENT APPLICATION

(11) **EP 4 734 676 A1**
(43) Date of publication of application: **29.04.2026**
(21) Application number: 24853165.9
(22) Date of filing: 08.03.2024
(51) Int. Cl.: H05K 5/02

(54) **HOUSING FOR FOLDABLE ELECTRONIC DEVICE, AND FOLDABLE ELECTRONIC DEVICE**

(30) Priority: 14.08.2023 CN 202311028434
(71) Applicant: Honor Device Co., Ltd., Shenzhen, Guangdong 518040 (CN)
(72) Inventor: WANG, Chenyu, Shenzhen, Guangdong 518040 (CN); LIU, Yang, Shenzhen, Guangdong 518040 (CN); LI, Jianping, Shenzhen, Guangdong 518040 (CN); ZHAO, Zhe, Shenzhen, Guangdong 518040 (CN); HE, Xinwei, Shenzhen, Guangdong 518040 (CN)
(74) Representative: Goddar, Heinz J.
(86) International application number: PCT/CN2024/080807
(87) International publication number: WO 2025/035749

(57) **Abstract**

This application provides a housing for a foldable electronic device, and a foldable electronic device. The housing includes a middle plate, the middle plate includes a first middle plate and a second middle plate that are connected to each other, and materials of the first middle plate and the second middle plate are different. The first middle plate and the second middle plate are mated with each other to form a hinge accommodating region and a non-hinge accommodating region on the middle plate, at least a portion of the first middle plate forms at least a portion of the non-hinge accommodating region, and at least a portion of the second middle plate forms at least a portion of the hinge accommodating region. The middle plate of the housing provided in this application uses a split-type structure and uses different materials, thereby maintaining stable chemical performance when implementing reduction of a body weight.

## Description

This application claims priority to Chinese Patent Application No. 202311028434.8, filed with the China National Intellectual Property Administration on August 14, 2023 and entitled "HOUSING FOR FOLDABLE ELECTRONIC DEVICE, AND FOLDABLE ELECTRONIC DEVICE", which is incorporated herein by reference in its entirety.

### TECHNICAL FIELD

This application relates to the field of foldable electronic devices, and more specifically, to a housing for a foldable electronic device, and a foldable electronic device.

### BACKGROUND

A foldable electronic device generally includes a housing assembly and a display, and the housing assembly is configured to support the display. The housing assembly includes two housings and a hinge mechanism that is rotatably connected between the two housings. Each housing includes a middle plate and an outer frame disposed around an outer peripheral side of the middle plate, and two sides of the hinge mechanism are respectively connected to middle plates of the two housings. In the industry, a middle plate of a foldable electronic device is mostly an integral structure made of an alloy material, that is, the entire middle plate is made of a same alloy material. Different alloys have different characteristics. Limited by a single material, the middle plate of the integral structure cannot balance various performance. For example, to reduce a weight of a body, some manufacturers use a low-density alloy material (for example, a magnesium alloy) to manufacture the middle plate, and the low-density alloy material may be, for example, a magnesium alloy. However, the magnesium alloy has unstable chemical performance and poor corrosion resistance, and a potential difference between the magnesium alloy and a material (for example, stainless steel) used by the hinge mechanism is relatively large. Consequently, galvanic corrosion easily occurs between the middle plate and the hinge mechanism, a degree of galvanic corrosion is relatively serious, and a relatively large quantity of corrosion products are generated. In addition, the corrosion products accumulate at a position at which the middle plate is mated with the hinge mechanism, and this easily causes the hinge mechanism to jam and a screen to be pushed up and fail. These problems affect use experience of a consumer. If an alloy material (for example, an aluminum alloy) with a relatively stable chemical property is used to make the middle plate to reduce galvanic corrosion between the hinge mechanism and the middle plate, the weight of the body may be increased due to a relatively high material density, and this is not conducive to lightening and thinning of the body.

Therefore, limited by a single material, a middle plate of a foldable electronic device in a conventional technology cannot balance various performance, for example, can hardly maintain stable chemical performance when implementing reduction of a body weight, thereby affecting use experience of a consumer.

### SUMMARY

Embodiments of this application provide a housing for a foldable electronic device, and a foldable electronic device, to resolve a problem that, limited by a single material, a middle plate of a foldable electronic device in a conventional technology can hardly maintain stable chemical performance when implementing reduction of a body weight, thereby affecting use experience of a consumer.

An embodiment of this application provides a housing for a foldable electronic device, including a middle plate. The middle plate has a hinge accommodating region and a non-hinge accommodating region, and the hinge accommodating region is configured to accommodate and mount a hinge mechanism of the foldable electronic device.

The middle plate includes a first middle plate and a second middle plate that are connected to each other, at least a portion of the first middle plate forms at least a portion of the non-hinge accommodating region, at least a portion of the second middle plate forms at least a portion of the hinge accommodating region, and a material of the first middle plate is different from a material of the second middle plate.

According to the housing provided in this application, a middle plate portion includes the first middle plate and the second middle plate that are made of different materials, and the first middle plate and the second middle plate are mated with each other to form the hinge accommodating region and the non-hinge accommodating region on the middle plate. The hinge accommodating region is mainly configured to accommodate and mount a hinge of the foldable electronic device, and the non-hinge accommodating region is mainly configured to support and protect an internal component of the foldable electronic device. At least a portion of the first middle plate forms at least a portion of the non-hinge accommodating region, and at least a portion of the second middle plate forms at least a portion of the hinge accommodating region. It may be understood that the hinge accommodating region mainly includes the second middle plate, and the non-hinge accommodating region mainly includes the first middle plate.

The first middle plate and the second middle plate use a split-type structure and use different materials, so that diversity of the middle plate materials is improved, and selection is more flexible. This helps balance a physical property and a chemical property of the middle plate. For example, the second middle plate has a larger contact area with the hinge mechanism and may use a material with a relatively stable chemical property, or the material of the first middle plate is selected based on a material of the hinge mechanism, to reduce a risk of galvanic corrosion between the first middle plate and the hinge mechanism. The first middle plate has a smaller contact area with the hinge mechanism, a physical property may be mainly focused on, and a lightweight material with a low density may be selected to reduce a weight of a body. Therefore, material selection for the housing provided in this application is more flexible. This can maintain stable chemical performance when implementing reduction of a body weight, thereby improving use experience of a consumer.

In some embodiments, a portion of the first middle plate forms the entirety of the non-hinge accommodating region, and the other portion of the first middle plate and the entire second middle plate jointly form the entirety of the hinge accommodating region. Alternatively, the entire first middle plate forms the entirety of the non-hinge accommodating region, and the entire second middle plate forms the entirety of the hinge accommodating region.

In some embodiments, the first middle plate includes a first support plate and a first side wall, the first support plate has a first surface and a second surface that are disposed opposite to each other along a thickness direction of the first support plate, and the first side wall is connected to a side edge of the first support plate and protrudes from the second surface of the first support plate. The second middle plate includes a second support plate and a second side wall, the second support plate has a first surface and a second surface that are disposed opposite to each other along a thickness direction of the second support plate, and the second side wall is connected to a side edge of the second support plate and protrudes from the first surface of the second support plate.

The second side wall is connected to the first side wall, the second support plate is located on an outer side of the side edge of the first support plate and is spaced apart from the first support plate along a thickness direction of the middle plate, and a surface that is of the second support plate and that faces the first support plate is the first surface of the second support plate.

The first support plate integrally forms the entirety of the non-hinge accommodating region, and the second support plate, the second side wall, and the first side wall collectively form at least a portion of the hinge accommodating region, where the second support plate forms a base plate of the hinge accommodating region, and the first side wall and the second side wall jointly form a side wall of the hinge accommodating region, and together with the second support plate, enclose a space for accommodating the hinge mechanism.

In the foregoing structure, the first support plate and the second support plate are separated by the side wall of the hinge accommodating region, and the hinge mechanism of the foldable electronic device is in contact with only the base plate and the side wall of the hinge accommodating region, and is not in contact with the first support plate. This prevents galvanic corrosion between the hinge mechanism and the first support plate, reduces a risk that the first support plate cannot support and protect an internal component after being corroded, and avoids accumulation of corrosion products to prevent screen failure. The side wall of the hinge accommodating region includes the first side wall and the second side wall. Compared with a solution in which the second side wall of the second middle plate forms the side wall of the hinge accommodating region, this structure can securely combine the first middle plate and the second middle plate by using a connection structure between the first side wall and the second side wall. Compared with a solution in which the first side wall of the first middle plate forms the side wall of the hinge accommodating region, this structure can reduce a contact area between the hinge mechanism and the first side wall, and reduce a tendency for galvanic corrosion to occur between the first side wall and the hinge mechanism, thereby reducing a risk of hinge jamming.

In some embodiments, a limiting structure is disposed at a position at which the second side wall is connected to the first side wall, and the limiting structure is configured to make the first middle plate and the second middle plate relatively fastened. Because there is no bonding force between a material surface of the first middle plate and a material surface of the second middle plate, connection and fastening need to be performed by using the limiting structure.

In some embodiments, the limiting structure includes at least one snap-on structure, each snap-on structure in the at least one snap-on structure includes a snap groove and a boss that is snapped into the snap groove, one of the snap groove and the boss is located on the first side wall of the middle plate, and the other is located on the second side wall of the middle plate. The boss of the snap-on structure is snapped into the snap groove, thereby limiting relative movement between the first middle plate and the second middle plate.

In some embodiments, in each snap-on structure, the snap groove is formed by being recessed toward an interior of the first side wall from a side surface that is of the first side wall and that faces away from the first support plate, and the boss is formed by extending outward from a side surface that is of the second side wall and that faces away from the second support plate. That is, the snap groove is located on the first side wall, and the boss is located on the second side wall.

In some embodiments, at least a portion of the at least one snap-on structure is disposed as a dovetail groove structure, and in each dovetail groove structure, the snap groove is disposed as a dovetail groove, two side surfaces of the dovetail groove are disposed opposite to each other along a length direction of the middle plate, and a groove width of the dovetail groove gradually increases from a groove opening to a groove bottom; and the boss is disposed as a structure that matches a shape of the dovetail groove, to limit relative movement between the first middle plate and the second middle plate along the length direction and a width direction of the middle plate. The dovetail groove reduces a width of an opening of the snap groove, so that the boss does not easily separate from the snap groove along the width direction of the middle plate, thereby improving snapping reliability.

In some embodiments, in each dovetail groove structure, the boss has a first end surface and a second end surface that are disposed opposite to each other along the thickness direction of the middle plate, and the second end surface faces the second support plate; and in at least some dovetail groove structures, the first end surface and/or the second end surface are/is configured as an inclined surface relative to a first plane, and a surface that is of the dovetail groove and that is disposed opposite to the inclined surface of the boss is configured as a matching inclined surface, to limit relative movement between the first middle plate and the second middle plate along the width direction of the middle plate, where the first plane is perpendicular to the thickness direction of the middle plate.

In some embodiments, at least a portion of the at least one snap-on structure is disposed as an undercut structure, and in each undercut structure, the boss has a first end surface and a second end surface that are disposed opposite to each other along the thickness direction of the middle plate, and the second end surface faces the second support plate; and the first end surface and/or the second end surface are/is configured as an inclined surface relative to a second plane, and a surface that is of the snap groove and that is disposed opposite to the inclined surface of the boss is configured as a matching inclined surface, to limit relative movement between the first middle plate and the second middle plate along the width direction of the middle plate, where the second plane is perpendicular to the thickness direction of the middle plate.

In the foregoing solution, the boss is mated with the snap groove by using inclined surfaces, and both the inclined surface of the boss and the inclined surface of the snap groove are inclined relative to the first plane or the second plane. When there is a tendency for the first middle plate and the second middle plate to separate from each other, inclined surfaces between the first middle plate and the second middle plate abut against each other, an interaction force between the inclined surfaces may be decomposed into a force along the thickness direction of the middle plate and a force along the width direction of the middle plate, and the force along the width direction of the middle plate may prevent the first middle plate and the second middle plate from separating from each other.

In some embodiments, the at least one snap-on structure is a plurality of snap-on structures. Use of the plurality of snap-on structures reduces a risk that failure of a snap-on structure causes the first middle plate to separate from the second middle plate, thereby improving reliability of combining the first middle plate and the second middle plate.

In some embodiments, the plurality of snap-on structures form at least one column of snap-on structures, and each column of snap-on structures in the at least one column of snap-on structures includes at least two snap-on structures spaced apart along the length direction of the middle plate. In this structure, the snap-on structures are arranged in an orderly manner. This is convenient for processing and manufacturing, and can ensure that a joint surface between the first side wall and the second side wall is under uniform stress, thereby improving connection strength.

In some embodiments, the at least one column of snap-on structures is two columns of snap-on structures, and the two columns of snap-on structures are spaced apart along the thickness direction of the middle plate. It may be understood that the snap groove does not penetrate the first side wall along the thickness direction of the middle plate. Therefore, the snap-on structures may limit relative movement between the first middle plate and the second middle plate along the thickness direction of the middle plate.

In some embodiments, one column of snap-on structures in the two columns of snap-on structures is disposed on a top surface of the side wall of the hinge accommodating region, the other column of snap-on structures is disposed on a bottom surface of the side wall of the hinge accommodating region, the top surface of the side wall of the hinge accommodating region is connected to the first surface of the first support plate, and the bottom surface of the side wall of the hinge accommodating region is connected to the second surface of the second support plate. This improves flatness of a surface of the foldable electronic device, and improves use experience of a consumer.

In some embodiments, the limiting structure includes at least one snap-fit structure, and each snap-fit structure in the at least one snap-fit structure includes a snap-fit structure body and a snap-fit groove that are interlocked with each other.

The snap-fit structure body is formed by extending outward from a side surface that is of the second side wall and that faces away from the second support plate, and includes a cantilever and two connecting arms spaced apart along a length direction of the cantilever; and the cantilever is disposed opposite to and spaced apart from the second side wall, one end of each connecting arm in the two connecting arms is connected to the cantilever, the other end of each connecting arm is connected to the second side wall, and the snap-fit groove is formed in the first side wall and configured as a groove structure that matches a shape of the snap-fit structure body.

The snap-fit structure body has a top surface and a bottom surface that are disposed opposite to each other along the thickness direction of the middle plate, and a side surface that is connected to the top surface and the bottom surface and that faces away from the second side wall. After assembly, the top surface of the snap-fit structure body and a top surface of the first support plate are in a same plane, and the bottom surface and the side surface of the snap-fit structure body abut against the snap-fit groove, thereby limiting movement of the second middle plate toward the second support plate along the thickness direction of the middle plate, and movement of the second middle plate toward the first side wall along the width direction of the middle plate. A protruding portion of the snap-fit groove extends into a gap between the two connecting arms, thereby limiting relative movement between the first middle plate and the second middle plate along the width direction of the middle plate.

In some embodiments, the second support plate is provided with a plurality of mounting holes, and a fastener is disposed through each of the plurality of mounting holes, so that the second support plate may be fastened and detachably connected to the hinge mechanism, where axes of all of the plurality of mounting holes are not in a same plane. The second support plate and the hinge mechanism are connected by using the fastener, providing a secure connection that is flexibly detachable, to facilitate replacement and maintenance of a structural component.

In some embodiments, the second middle plate is provided with accommodating spaces at positions corresponding to at least some of the plurality of mounting holes, and each accommodating space is formed by being recessed toward an interior of the second support plate along the width direction of the middle plate from a side surface that is of the second side wall and that faces the first side wall, and communicates with a corresponding mounting hole.

A protruding reinforcing plate corresponding to each accommodating space is disposed on a side surface that is of the first side wall and that faces the second side wall, the reinforcing plate extends into the corresponding accommodating space and is provided with a connection hole aligned with the corresponding mounting hole, and the fastener is disposed through each connection hole and the corresponding mounting hole, so that the second support plate and the reinforcing plate may be fastened and detachably connected to the hinge mechanism.

In the foregoing solution, the second support plate and the reinforcing plate of the first middle plate are connected by using the fastener, thereby increasing a joint position between the first middle plate and the second middle plate. Based on the limiting structure on the first side wall and the second side wall, strength of a connection structure between the first middle plate and the second middle plate is further improved.

In some embodiments, the reinforcing plate is fully embedded in the second support plate.

In some embodiments, the first middle plate further includes at least one extension portion, and each extension portion in the at least one extension portion extends toward a direction of the second support plate from the side surface that is of the first side wall and that faces away from the first support plate; the second middle plate is provided with a notch at a position corresponding to each extension portion, and the extension portion is located in the notch; and the extension portion has a first surface and a second surface that are disposed opposite to each other along a thickness direction of the extension portion, the first surface of the extension portion is connected to the first surface of the second support plate, the second surface of the extension portion is connected to the second surface of the second support plate, and the at least one extension portion and the second support plate jointly form the base plate of the hinge accommodating region. The extension portion is configured to implement an electrical connection between the first middle plate and the hinge.

In some embodiments, each extension portion is provided with a fastening hole and a spring plate mounting groove. A fastener is disposed through the fastening hole, so that the extension portion may be fastened and detachably connected to the hinge mechanism. A region on an outer peripheral side of the fastening hole is attached with an annular insulating film surrounding the fastening hole, and the insulating film is not electrically conductive, to prevent galvanic corrosion in the covered region. A spring plate is mounted in the spring plate mounting groove, and the spring plate abuts against the hinge mechanism, to implement an electrical connection between the first middle plate and the hinge mechanism. Annular foam surrounding the spring plate is disposed on an inner wall surface of the spring plate mounting groove. The annular foam implements a waterproofing function, to prevent galvanic corrosion by preventing electrolytes from entering the spring plate mounting groove.

In some embodiments, an avoidance space for a signal line to pass through is provided between the first middle plate and the second middle plate.

In some embodiments, the first middle plate is an integral structure made of an alloy material, and the second middle plate is an integral structure made of an alloy material or plastic.

In some embodiments, when both the first middle plate and the second middle plate are integral structures made of alloy materials, a density of the first middle plate is less than a density of the second middle plate.

The hinge mechanism has a mating component in contact with the second middle plate, a material of the mating component is an alloy, and an absolute value of a potential difference between the alloy material of the mating component and an alloy material of the second middle plate is less than an absolute value of a potential difference between the alloy material of the mating component and an alloy material of the first middle plate.

A larger potential difference between two metals leads to a greater tendency for galvanic corrosion. In the foregoing solution, a risk of galvanic corrosion between the hinge mechanism and the first middle plate may be reduced when weight reduction is implemented for the entire device.

In some embodiments, when both the first middle plate and the second middle plate are integral structures made of alloy materials, a material of the first middle plate is a magnesium alloy, and a material of the second middle plate is an aluminum alloy. A material of the hinge mechanism is generally stainless steel. A potential difference between the aluminum alloy and the hinge mechanism made of the stainless steel is less than a potential difference between the magnesium alloy and the hinge mechanism made of the stainless steel, and a density of the magnesium alloy is less than a density of the aluminum alloy. In this structure, a contact area between the magnesium alloy and the hinge mechanism is reduced, galvanic corrosion is controlled in a specific range, and weight reduction is implemented for the entire device.

An embodiment of this application further provides a foldable electronic device, including a hinge mechanism, and a first housing and a second housing that are disposed on two sides of the hinge mechanism. The first housing and the second housing are rotatably connected by using the hinge mechanism, so that the first housing and the second housing can be relatively expanded or folded. At least one of the first housing and the second housing uses the housing provided in any one of the foregoing embodiments. The foldable electronic device provided in this application can reduce or even eliminate a risk of galvanic corrosion when implementing weight reduction for the entire device, thereby reducing risks of hinge jamming and screen failure, improving a service life of the foldable electronic device, and improving user experience.

In some embodiments, each of the first housing and the second housing uses the housing provided in any one of the foregoing embodiments.

In some embodiments, the hinge mechanism includes a base, and a first rotating arm and a second rotating arm that are disposed on two sides of the base; one end of the first rotating arm is rotatably connected to one side of the base, and the other end is connected to a hinge accommodating region of a middle plate of the first housing by using a first connecting bracket; and one end of the second rotating arm is rotatably connected to the other side of the base, and the other end is connected to a hinge accommodating region of a middle plate of the second housing by using a second connecting bracket, to combine the hinge region with the middle plate.

### BRIEF DESCRIPTION OF DRAWINGS

FIG. 1 is a diagram of a structure of a housing of a foldable electronic device in some solutions;
FIG. 2 is a diagram of mating between a housing and a hinge mechanism of a foldable electronic device in some solutions;
FIG. 3 is a diagram of an exploded structure of a foldable electronic device according to an embodiment of this application;
FIG. 4A is a diagram of a structure of a foldable electronic device in an open state according to an embodiment of this application;
FIG. 4B is a diagram of a structure of a foldable electronic device in a folded state according to an embodiment of this application;
FIG. 4C is a diagram of a structure of a foldable electronic device in a folding process according to an embodiment of this application;
FIG. 5 is a diagram of mating between a hinge mechanism and a housing of a foldable electronic device according to an embodiment of this application;
FIG. 6 is a diagram of a principle structure of a housing of a foldable electronic device according to an embodiment of this application;
FIG. 7 is a diagram of a principle structure of mating between a housing and a hinge mechanism of a foldable electronic device according to an embodiment of this application;
FIG. 8A is a diagram of a front view structure of a housing of a foldable electronic device according to an embodiment of this application;
FIG. 8B is a diagram of a rear view structure of a housing of a foldable electronic device according to an embodiment of this application;
FIG. 9 is a cutaway diagram along an I-I direction in FIG. 8A;
FIG. 10 is a diagram of a structure of a first middle plate in a housing of a foldable electronic device according to an embodiment of this application;
FIG. 11 is a diagram of a structure of a second middle plate in a housing of a foldable electronic device according to an embodiment of this application;
FIG. 12A to FIG. 12C are diagrams of a dovetail groove structure in a housing of a foldable electronic device according to an embodiment of this application;
FIG. 13A to FIG. 13C are diagrams of an undercut structure in a housing of a foldable electronic device according to an embodiment of this application;
FIG. 14A to FIG. 14D are diagrams of a snap-fit structure in a housing of a foldable electronic device according to an embodiment of this application;
FIG. 15 is a diagram of a principle of a connection between a housing and a hinge mechanism of a foldable electronic device according to an embodiment of this application;
FIG. 16A is a diagram of a cross-sectional structure along an E-E direction in FIG. 11;
FIG. 16B is a diagram of a structure of a reinforcing plate of a first middle plate in a housing of a foldable electronic device according to an embodiment of this application; and
FIG. 17 is a diagram of a structure of an extension portion of a first middle plate in a housing of a foldable electronic device according to an embodiment of this application.

### Descriptions of reference numerals:

In some solutions:
100': housing; 1': middle plate; 200': hinge mechanism.

In this application:
100: foldable electronic device;
10: housing assembly; 20: hinge mechanism; 201: first rotating arm; 202: first connecting bracket; 203: base;
30: screen; 301: first portion; 302: second portion; 303: foldable portion;
101: first housing; 102: second housing; 10x: housing; 110: middle plate; 120: outer frame;
A: hinge accommodating region; B: non-hinge accommodating region;
1: first middle plate; 11: first side wall; 11a: inner wall surface; 11b: outer wall surface; 11c: upper surface; 11d: lower surface;
12: first support plate; 12a: first surface; 12b: second surface;
2: second middle plate; 21: second side wall; 21a: inner wall surface; 21b: outer wall surface; 21c: upper surface; 21d: lower surface;
22: second support plate; 22a: first surface; 22b: second surface;
3: snap-on structure; 31: snap groove; 32: boss; 33: first end surface; 34: second end surface;
3a: dovetail groove structure; 31a: dovetail groove; 32a: boss; 33a: first end surface; 34a: second end surface; M: first plane;
3b: undercut structure; 31b: snap groove; 32b: boss; 33b: first end surface; 34b: second end surface; N: second plane;
4: snap-fit structure; 41: snap-fit structure body; 42: snap-fit groove; 411: cantilever; 412: connecting arm;
41a: top surface; 41b: bottom surface; 41c: side surface;
51: mounting hole; 52: connection hole; 53: fastening hole; 61: accommodating space; 62: reinforcing plate;
71: extension portion; 71a: first surface; 71b: second surface; 72: notch;
8: spring plate mounting groove; 9: avoidance space; and
Z: thickness direction of the middle plate; X: width direction of the middle plate; Y: length direction of the middle plate.

### DESCRIPTION OF EMBODIMENTS

Implementations of this application are described below by using specific embodiments, and a person skilled in the art can easily understand other advantages and effects of this application from content disclosed in this specification. Although description of this application is provided with reference to some embodiments, this does not represent that features of this application are limited to this implementation. On the contrary, a purpose of describing this application with reference to the implementation is to cover other options or modifications that may be derived based on claims of this application. To provide an in-depth understanding of this application, some descriptions include many specific details. This application may be practiced without these details. In addition, to avoid confusing or obscuring a focus of this application, some specific details are omitted from the description. It should be noted that embodiments in this application and the features in embodiments may be combined with each other in a case that no conflict occurs.

In the descriptions of this application, it should be noted that, unless otherwise expressly specified and limited, terms "mount", "connection", and "connect" should be understood in a broad sense, for example, may indicate a fixed connection, a detachable connection, an integral connection, a mechanical connection, an electrical connection, mutual communication, a direct connection, an indirect connection through an intermediate medium, an internal connection between two elements, or an interaction relationship between two elements. A person of ordinary skill in the art may understand specific meanings of the foregoing terms in this application based on specific cases.

In the descriptions of this application, it should be understood that an orientation relationship or a position relationship indicated by terms such as "up", "down", "side", "in", "out", "top", and "bottom" are an orientation relationship or a position relationship based on mounting, and is merely for ease of description of this application and simplification of the description, but is not intended to indicate or imply that a specified apparatus or element necessarily has a specific orientation or is constructed and operated in a specific orientation. Therefore, the terms cannot be construed as a limitation on this application. In addition, terms "first" and "second" are used for description only, and cannot be construed as indicating or implying relative importance.

In the descriptions of this application, limitations such as collinear, coaxial, coplanar, symmetrical, parallel, and perpendicular are all based on a current technological level, rather than absolute strict definitions in a mathematical sense.

It should be further noted that in embodiments of this application, a same reference numeral represents a same component part or a same component. For a same component in embodiments of this application, only one part or component may be used as an example in the figure to mark a reference numeral. It should be understood that, for another same part or component, the reference numeral is also applicable.

To make the objectives, technical solutions, and advantages of this application clearer, the following further describes implementations of this application in detail with reference to the accompanying drawings.

A foldable electronic device generally includes a housing assembly and a display, and the housing assembly is configured to support the display. The housing assembly includes two housings and a hinge mechanism that is rotatably connected between the two housings. Each housing includes a middle plate and an outer frame disposed around an outer peripheral side of the middle plate, and two sides of the hinge mechanism are respectively connected to middle plates of the two housings. In the industry, a middle plate of a foldable electronic device is mostly an integral structure made of an alloy material, that is, the entire middle plate is made of a same alloy material.

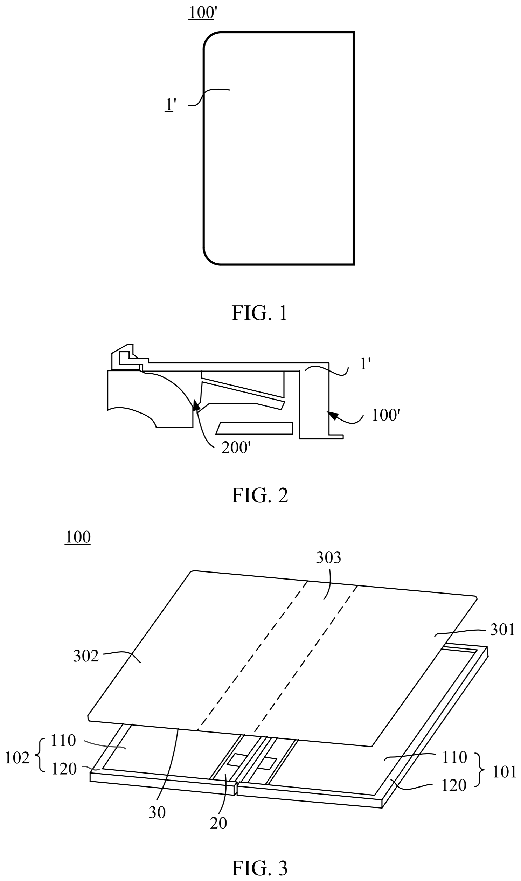

Refer to FIG. 1 and FIG. 2. FIG. 1 is a diagram of a structure of a housing of a foldable electronic device in some solutions. FIG. 2 is a diagram of mating between a housing and a hinge mechanism of a foldable electronic device in some solutions.

As shown in FIG. 1 and FIG. 2, a middle plate 1' of a housing 100' of the foldable electronic device is an integral structure made of an alloy material, that is, the entire middle plate 1' is made of a same alloy material, and a hinge mechanism 200' of the foldable electronic device is mounted on the middle plate 1' and has a large area of contact with the middle plate 1'. Different alloys have different characteristics. Limited by a single material, the middle plate 1' of the integral structure cannot balance various performance. For example, to reduce a weight of a body, some manufacturers use a low-density alloy material (for example, a magnesium alloy) to manufacture the middle plate 1', and the low-density alloy material may be, for example, a magnesium alloy. However, the magnesium alloy has unstable chemical performance and poor corrosion resistance, and a potential difference between the magnesium alloy and a material (for example, stainless steel) used by the hinge mechanism is relatively large. Consequently, galvanic corrosion easily occurs between the middle plate and the hinge mechanism, a degree of galvanic corrosion is relatively serious, and a relatively large quantity of corrosion products are generated. In addition, the corrosion products accumulate at a position at which the middle plate is mated with the hinge mechanism, and this easily causes the hinge mechanism to jam and a screen to be pushed up and fail. These problems affect use experience of a consumer. If an alloy material (for example, an aluminum alloy) with a relatively stable chemical property is used to make the middle plate to reduce galvanic corrosion between the hinge mechanism and the middle plate, the weight of the body may be increased due to a relatively high material density, and this is not conducive to lightening and thinning of the body.

Therefore, limited by a single material, the housing of the foldable electronic device cannot balance various performance, for example, can hardly maintain stable chemical performance when implementing reduction of a body weight, thereby affecting use experience of a consumer.

To resolve the foregoing problems, this application provides a housing for a foldable electronic device, and a foldable electronic device. A middle plate of the housing is disposed as a first middle plate and a second middle plate that use different materials, so that diversity of the middle plate materials is improved, and selection is more flexible. This helps balance a physical property and a chemical property of the middle plate, and can balance various performance, for example, can maintain stable chemical performance when implementing reduction of a body weight, thereby improving use experience of a consumer.

The foldable electronic device provided in embodiments of this application may be a foldable mobile phone, a foldable computer, a foldable e-reader, a foldable display device, a wearable device, an in-vehicle device, or the like. A specific type of the foldable electronic device is not limited in embodiments of this application. The following uses the foldable mobile phone as an example to describe a structure of the foldable electronic device.

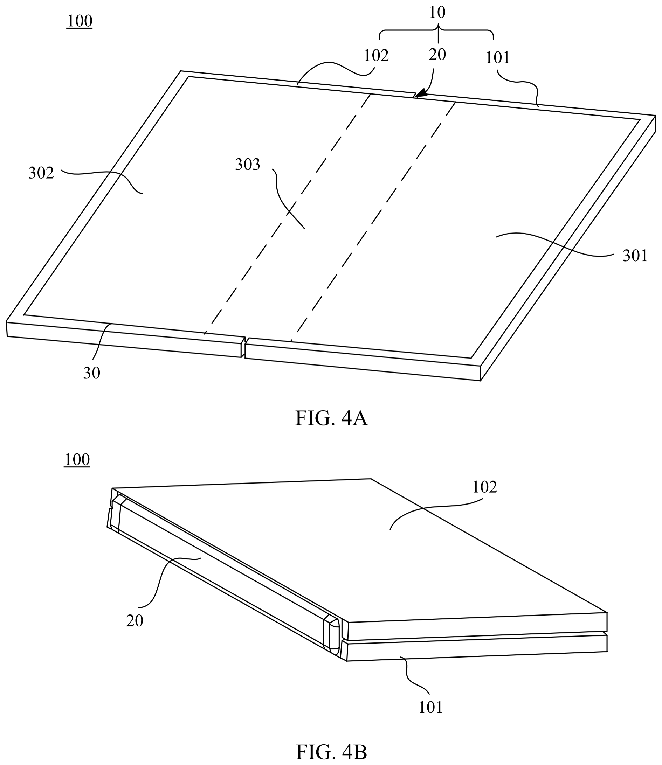

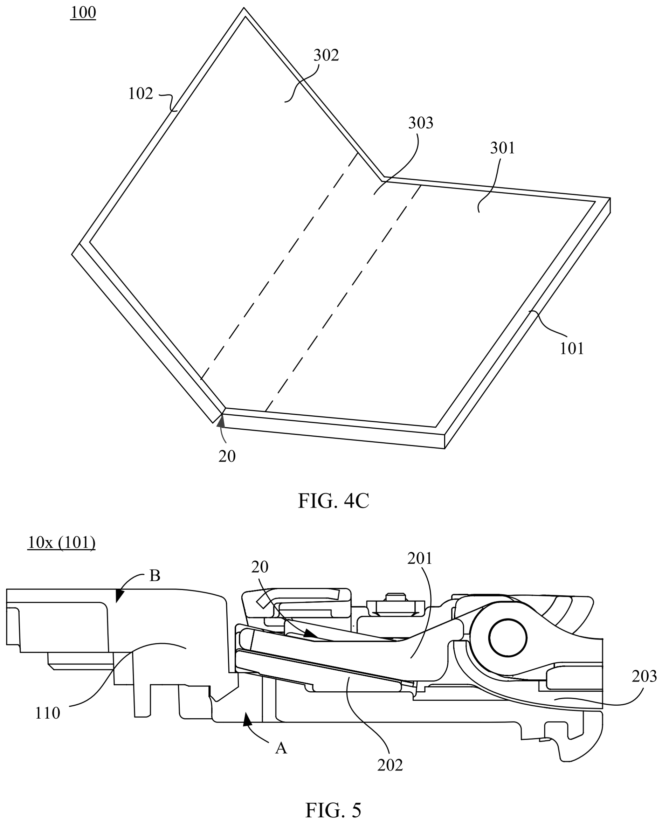

Refer to FIG. 3 to FIG. 4C. FIG. 3 is a diagram of an exploded structure of a foldable electronic device according to an embodiment of this application. FIG. 4A is a diagram of a structure of a foldable electronic device in an open state according to an embodiment of this application. FIG. 4B is a diagram of a structure of a foldable electronic device in a folded state according to an embodiment of this application. FIG. 4C is a diagram of a structure of a foldable electronic device in a folding process according to an embodiment of this application.

As shown in FIG. 3 to FIG. 4C, a foldable electronic device 100 includes a first housing 101, a second housing 102, and a hinge mechanism 20. The first housing 101 and the second housing 102 are rotatably connected by using the hinge mechanism 20, to implement opening and folding of the foldable electronic device 100. Each housing 10x in the first housing 101 and the second housing 102 is a frame portion of the foldable electronic device 100, and is configured to support and protect an internal element of the foldable electronic device 100. The first housing 101, the second housing 102, and the hinge mechanism 20 jointly form a housing assembly 10.

A person skilled in the art may understand that specific structures of the first housing 101 and the second housing 102 are not limited. In an implementation, the first housing 101 and the second housing 102 may each include a middle plate 110 and an outer frame 120 disposed around an outer peripheral side of the middle plate. The middle plate 110 is configured to mount a circuit board and support an electronic element. The specific structures of the housings are described in the following.

It should be noted that the foldable electronic device 100 has the open state and the folded state. Both the first housing 101 and the second housing 102 may rotate around the hinge mechanism 20, so that the first housing 101 and the second housing 102 rotate relative to each other. When the first housing 101 and the second housing 102 rotate relative to each other to be coplanar, the foldable electronic device is in the open state shown in FIG. 4A. In this case, there is a specific angle between the first housing 101 and the second housing 102. In an example scenario, when the foldable electronic device 100 is in the open state, an included angle between the first housing 101 and the second housing 102 is 180°. A person skilled in the art may understand that the included angle between the first housing 101 and the second housing 102 may be 90°, 120°, 210°, or the like. This is not limited in this application.

Further, when the first housing 101 and the second housing 102 rotate relative to each other to be mutually stacked, the foldable electronic device 100 is in the folded state shown in FIG. 4B. In this case, the included angle between the first housing 101 and the second housing 102 may be approximately considered as 0°.

It should be noted that all angles exemplified in this application are allowed to have slight deviations. For example, when the foldable electronic device 100 is in the open state, the angle at which the foldable electronic device is opened may be 180°, or may be approximately 180°, for example, 170°, 175°, 185°, or 190°. Another angle may also have the same understanding in the following.

As shown in FIG. 4C, the foldable electronic device 100 may alternatively be in a state between the folded state and the open state. For example, the first housing 101 and the second housing 102 may alternatively form a specific included angle, so that the foldable electronic device 100 switches to a use mode in which the foldable electronic device can be placed on a desktop. In this case, the first housing 101 can be placed on a placement surface of a desk, a placement table, or the like, to ensure stable placement of the foldable electronic device 100.

In an implementation, the foldable electronic device further includes a screen 30 and a rear cover, and the screen 30 and the rear cover are disposed opposite to each other on two sides of the housing assembly 10 along a thickness direction of the foldable electronic device 100. The rear cover is configured to protect an internal structure of the foldable electronic device 100, and is also referred to as a battery cover. The screen 30 is configured to present an image and implement human-computer interaction. Optionally, the screen 30 may be an organic light-emitting diode (organic light-emitting diode, OLED) display, an active-matrix organic light-emitting diode (active-matrix organic light-emitting diode, AMOLED) display, a mini light-emitting diode (mini organic light-emitting diode) display, a micro light-emitting diode (micro organic light-emitting diode) display, a micro organic light-emitting diode (micro organic light-emitting diode) display, a quantum dot light-emitting diode (quantum dot light emitting diodes, QLED) display, or the like. This is not limited in this application.

Further, the screen 30 includes a first portion 301, a second portion 302, and a foldable portion 303. The first portion 301 is connected to the first housing 101, the second portion 302 is connected to the second housing 102, and the foldable portion 303 is located between the first portion 301 and the second portion 302, and is disposed corresponding to the hinge mechanism 20. During use of the foldable electronic device 100, the first portion 301 and the second portion 302 are always in a planar state, and the foldable portion 303 may be bent. When the first housing 101 and the second housing 102 are driven by the hinge mechanism 20 to rotate relative to each other, the first portion 301 and the second portion 302 of the screen 30 are also driven by the first housing 101 and the second housing 102 to rotate relative to each other, thereby implementing opening and folding of the screen 30.

Optionally, the screen 30 may be a fully foldable flexible screen, or the screen 30 may be a combination of a rigid screen and a flexible screen. For example, the foldable portion 303 is a foldable flexible screen, and the first portion 301 and the second portion 302 are rigid screens. This is not limited in this application.

It should be noted that the foldable electronic device 100 provided in this application may be an outward-folding electronic device or an inward-folding electronic device. As shown in FIG. 3 to FIG. 4C, in an implementation, the foldable electronic device 100 is an inward-folding electronic device. When the inward-folding electronic device is in the folded state, the housing assembly 10 surrounds an outer side of the screen 30. Alternatively, it may be understood that the first portion 301 and the second portion 302 of the screen 30 are disposed facing each other. When the first housing 101 and the second housing 102 rotate relative to each other to be coplanar, the foldable electronic device 100 is in the open state shown in FIG. 4A. In this case, an included angle between the first housing 101 and the second housing 102 is 180°, so that the foldable electronic device 100 can implement large-screen displaying, thereby providing a larger field of view, richer information, and better use experience for a user. When the first housing 101 and the second housing 102 rotate relative to each other to be mutually stacked, the foldable electronic device 100 is in the folded state shown in FIG. 4B. In this case, the included angle between the first housing 101 and the second housing 102 may be approximately considered as 0°. In this case, the foldable electronic device 100 has a smaller size, thereby facilitating the user in storing and carrying the foldable electronic device. The screen 30 is internally positioned, and the housing assembly 10 can protect the screen 30.

Optionally, the foldable electronic device 100 may further include a processor, a universal serial bus (universal serial bus, USB) interface, a charging management module, a power management module, a battery, a microphone, a motor, a speaker, a mobile communications module, an antenna, a wireless communications module, an audio module, a headset jack, a sensor module, a button, a camera, a subscriber identity module, and the like. It should be understood that the foldable electronic device 100 shown in FIG. 3 to FIG. 4C is only an example of a foldable electronic device, and does not constitute a specific limitation on the foldable electronic device in this embodiment of this application. The foldable electronic device may have more or fewer components than those shown in the figures.

A person skilled in the art may understand that a specific structure of the hinge mechanism 20 is not limited. It should be understood that the hinge mechanism 20 of the foldable electronic device 100 is mounted on the first housing 101 and the second housing 102, and has a large area of contact with the first housing 101 and the second housing 102. With reference to an accompanying drawing, the following describes an example of a possible structure of the hinge mechanism 20 and a position at which the hinge mechanism 20 is in contact with the first housing 101 and the second housing 102.

Refer to FIG. 5. FIG. 5 is a diagram of mating between a hinge mechanism and a housing of a foldable electronic device according to an embodiment of this application.

It should be noted that the hinge mechanism 20 may be designed symmetrically or asymmetrically. This is not limited in this application. Two sides of the hinge mechanism 20 are respectively connected to the first housing 101 and the second housing 102, and the first housing 101 and the second housing 102 may also be designed symmetrically or asymmetrically. In an implementation, the entire housing assembly 10 is designed symmetrically. That is, the two sides of the hinge mechanism 20 are symmetrical, and the first housing 101 and the second housing 102 are also symmetrical. The accompanying drawing provided in this application show only half of a symmetrical structure. That is, a housing 10x in FIG. 5 may be the first housing 101 or the second housing 102. In the figure, the first housing 101 is used as an example, and only a partial structure that is of the hinge mechanism 20 and that is mated with the first housing 101 is shown.

As shown in FIG. 5, in an implementation, the hinge mechanism 20 includes a base 203, and a first rotating arm 201 and a second rotating arm (not shown in the figure) that are disposed on two sides of the base 203. One end of the first rotating arm 201 is rotatably connected to one side of the base 203, and the other end is connected to the middle plate 110 of the first housing 101 by using a first connecting bracket 202. One end of the second rotating arm is rotatably connected to the other side of the base 203, and the other end is connected to the middle plate 110 of the second housing 102 by using a second connecting bracket (not shown in the figure), to combine the hinge mechanism 20 with the middle plate 110. The middle plate 110 of the first housing 101 and the middle plate 110 of the second housing 102 are both provided with hinge accommodating regions A, the first rotating arm 201 is connected to a hinge accommodating region A of the middle plate 110 of the first housing 101, and the second rotating arm is connected to a hinge accommodating region A of the middle plate 110 of the second housing 102. A region that is on the middle plate 110 and that is other than the hinge accommodating region A is a non-hinge accommodating region B. It may be understood that the hinge accommodating region A on each middle plate is a position at which the hinge mechanism 20 is in contact with the housing.

It should be noted that the first housing 101 and the second housing 102 may be designed symmetrically or asymmetrically. The following uses one housing 10x as an example to describe a structure of the housing 10x in detail with reference to an accompanying drawing. It should be noted that the other housing may also use the structure described below.

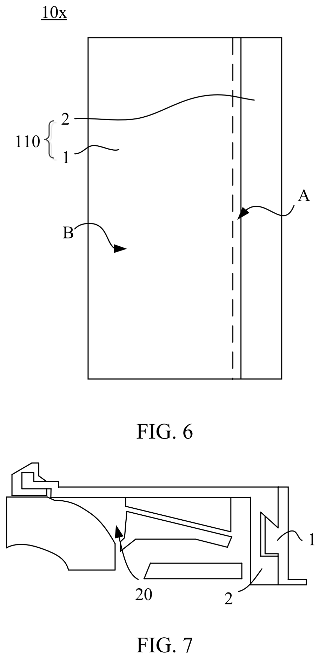

Refer to FIG. 6 and FIG. 7. FIG. 6 is a diagram of a principle structure of a housing of a foldable electronic device according to an embodiment of this application. FIG. 7 is a diagram of a principle structure of mating between a housing and a hinge mechanism of a foldable electronic device according to an embodiment of this application.

As shown in FIG. 3 to FIG. 4C and FIG. 6, the housing 10x includes a middle plate 110 and an outer frame 120. The middle plate 110 has enough structural strength to resist bending and impact fracture, and is configured to support and protect an internal element of the foldable electronic device 100. The outer frame 120 surrounds and is connected to an outer peripheral side of the middle plate 110. The outer frame 120 may be a metal outer frame, or may be a non-metal outer frame (such as a plastic outer frame or a glass outer frame). This is not limited in this application. The outer frame 120 of the first housing 101 is connected and fastened to the first portion 301, and/or a non-hinge accommodating region B of the first housing 101 may also be connected and fastened to the first portion 301. The outer frame 120 of the second housing 102 is connected and fastened to the second portion 302, and/or a non-hinge accommodating region B of the second housing 102 may also be connected and fastened to the second portion 302, so that the first housing 101 and the second housing 102 may firmly support the screen 30.

Further, the middle plate 110 has a hinge accommodating region A and a non-hinge accommodating region B. The hinge accommodating region A is configured to accommodate and mount the hinge mechanism 20 of the foldable electronic device 100, and another region is a non-hinge accommodating region B. It may be understood that the hinge accommodating region A of the housing is provided on the middle plate 110, and the hinge mechanism 20 is in contact with the hinge accommodating region A on the middle plate 110, and is not in contact with the non-hinge accommodating region B.

Further, the middle plate 110 includes a first middle plate 1 and a second middle plate 2 that are connected to each other, at least a portion of the first middle plate 1 forms at least a portion of the non-hinge accommodating region B, at least a portion of the second middle plate 2 forms at least a portion of the hinge accommodating region A, and a material of the first middle plate 1 is different from a material of the second middle plate 2.

Alternatively, it may be understood that the middle plate 110 includes the first middle plate 1 and the second middle plate 2 that are made of different materials, and the first middle plate 1 and the second middle plate 2 are mated with each other to form the hinge accommodating region A and the non-hinge accommodating region B on the middle plate 110. The hinge accommodating region A is mainly configured to accommodate and mount the hinge mechanism 20 of the foldable electronic device 100, and the non-hinge accommodating region B is mainly configured to support and protect an internal component of the foldable electronic device 100. At least a portion of the first middle plate 1 forms at least a portion of the non-hinge accommodating region B, and at least a portion of the second middle plate 2 forms at least a portion of the hinge accommodating region A. It may be understood that the hinge accommodating region A mainly includes the second middle plate 2, and the non-hinge accommodating region B mainly includes the first middle plate 1.

The first middle plate 1 and the second middle plate 2 use a split-type structure and use different materials, so that diversity of the middle plate materials is improved, and selection is more flexible. This helps balance a physical property and a chemical property of the middle plate. For example, the second middle plate 2 has a larger contact area with the hinge mechanism 20 and may use a material with a relatively stable chemical property, or the material of the first middle plate 1 is selected based on a material of the hinge mechanism, to reduce a risk of galvanic corrosion between the first middle plate 1 and the hinge mechanism 20. The first middle plate 1 has a smaller contact area with the hinge mechanism 20, a physical property may be mainly focused on, and a lightweight material with a low density may be selected to reduce a weight of a body. Therefore, material selection for the housing provided in this application is more flexible. This can maintain stable chemical performance when implementing reduction of a body weight, thereby improving use experience of a consumer.

A person skilled in the art may understand that materials of the first middle plate 1 and the second middle plate 2 are not limited. For example, both the first middle plate 1 and the second middle plate 2 may be made of materials such as metal or plastic, which may be specifically designed as required. In an implementation, the first middle plate 1 is an integral structure made of an alloy material, and the second middle plate 2 is an integral structure made of an alloy material or plastic.

Further, a density of the first middle plate 1 is less than a density of the second middle plate 2, to reduce a body weight of the foldable electronic device. In addition, the hinge mechanism 20 has a mating component (for example, each rotating arm) in contact with the second middle plate 2, a material of the mating component is an alloy, and an absolute value of a potential difference between the alloy material of the mating component and an alloy material of the second middle plate 2 is less than an absolute value of a potential difference between the alloy material of the mating component and an alloy material of the first middle plate 1. A larger potential difference between two metals leads to a greater tendency for galvanic corrosion to occur between the two metals, and a smaller potential difference may reduce a risk of galvanic corrosion. In the foregoing solution, an alloy material with a low density and an alloy material with a small potential difference relative to the hinge mechanism are combined. Compared with a middle plate made of a single alloy material, this structure can reduce a risk of galvanic corrosion between the hinge mechanism 20 and the middle plate 110 when implementing reduction of a body weight.

A person skilled in the art may understand that specific materials used by the first middle plate 1 and the second middle plate 2 are not limited. In an implementation, the material of the first middle plate 1 may be a magnesium alloy. The magnesium alloy has advantages such as a low density, high specific strength, and high heat dissipation performance. As a light metal, magnesium has a density of 1.74 g/cm³, which is about 2/3 of that of aluminum and 1/4 of that of steel, and is of great significance for implementing weight reduction for a foldable device. Under a same rigidity condition, 1 kg of magnesium alloy offers strength approximately equal to that of 18 kg of aluminum or 2 kg of steel, and can effectively support and protect an internal element of the foldable electronic device. High heat dissipation performance of the magnesium alloy is also suitable for the foldable electronic device with dense electronic elements. However, a standard electrode potential of Mg is -2.36 V, which is a most negative among industrial alloys, and oxidation products of Mg are loose and porous. Therefore, Mg and alloys of Mg have poor corrosion resistance and high chemical and electrochemical activity, and are prone to galvanic corrosion with other metals. Therefore, the second middle plate having a larger contact area with the hinge mechanism cannot use a magnesium alloy material.

In an implementation, the material of the second middle plate 2 may be an aluminum alloy. An electrode potential of aluminum is -1.66 V. A majority of the hinge mechanism 20 uses a stainless steel material, and an electrode potential of iron is -0.44 V. A potential difference between stainless steel and a magnesium alloy is about 1.93 V, and in an environment such as salt fog or seaside, galvanic corrosion easily occurs at a contact position. However, a potential difference between an aluminum alloy and stainless steel is about 1.22 V, which is less than the potential difference between the magnesium alloy and the stainless steel. Therefore, a tendency for galvanic corrosion between the second middle plate 2 made of the aluminum alloy and the hinge mechanism 20 made of the stainless steel is relatively small. In another alternative implementation, the material of the second middle plate 2 may alternatively be another alloy. For example, the material of the second middle plate 2 may be a titanium alloy. An electrode potential of titanium is -1.63 V, and a potential difference between titanium and stainless steel is about 1.19 V, which is less than the potential difference between the magnesium alloy and the stainless steel. Therefore, a tendency for galvanic corrosion between the second middle plate 2 made of the titanium alloy and the hinge mechanism 20 made of the stainless steel is relatively small. Alternatively, the material of the second middle plate 2 may be a zinc alloy. An electrode potential of zinc is -0.76 V, and a potential difference between zinc and stainless steel is about 0.32 V, which is also less than the potential difference between the magnesium alloy and the stainless steel. The material of the second middle plate 2 is not limited in this application.

A person skilled in the art may understand that sizes and positions of a region that is on the first middle plate 1 and that forms the non-hinge accommodating region B and a region that is on the second middle plate 2 and that forms the hinge accommodating region A are not limited. For example, the hinge accommodating region A may include a portion of the first middle plate 1 and a portion of the second middle plate 2, and the non-hinge accommodating region B may also include a portion of the first middle plate 1 and a portion of the second middle plate 2. Alternatively, the hinge accommodating region A may include only the second middle plate 2, and the non-hinge accommodating region B may include only the first middle plate 1. In an implementation, a portion of the first middle plate 1 forms the entirety of the non-hinge accommodating region B, and the other portion of the first middle plate 1 and the entire second middle plate 2 jointly form the entirety of the hinge accommodating region A. It may be understood that the non-hinge accommodating region B includes only the first middle plate 1, and the hinge accommodating region A includes all regions on the second middle plate 2 and a region that is on the first middle plate 1 and that is other than the non-hinge accommodating region B. In another alternative implementation, the entire first middle plate 1 forms the entirety of the non-hinge accommodating region B, and the entire second middle plate 2 forms the entirety of the hinge accommodating region A. This application does not provide exhaustive enumeration.

A person skilled in the art may understand that a specific structure of the middle plate is not limited. With reference to accompanying drawings, the following describes an example of a structure that may be used by the middle plate in this application.

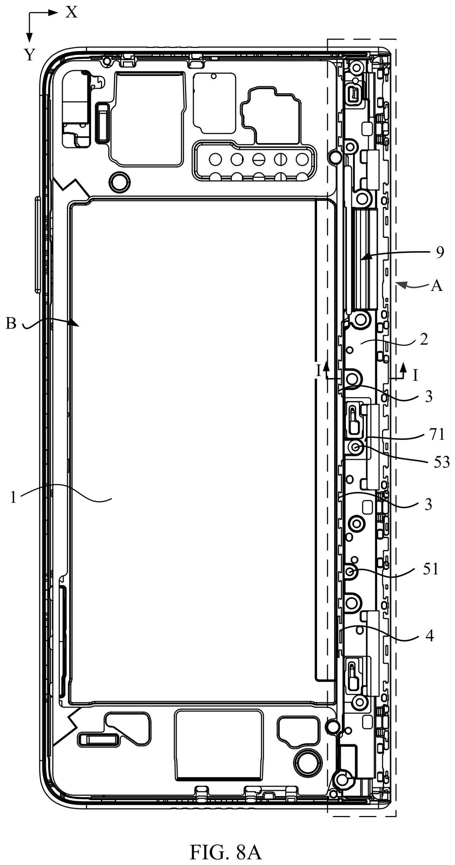

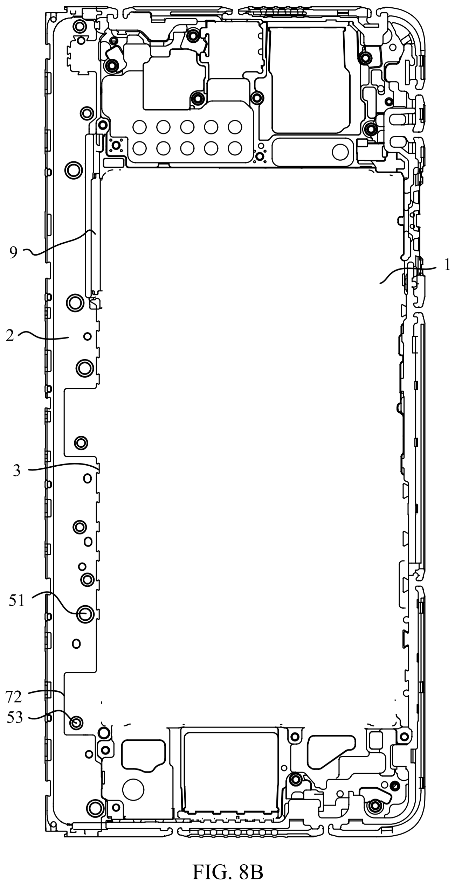

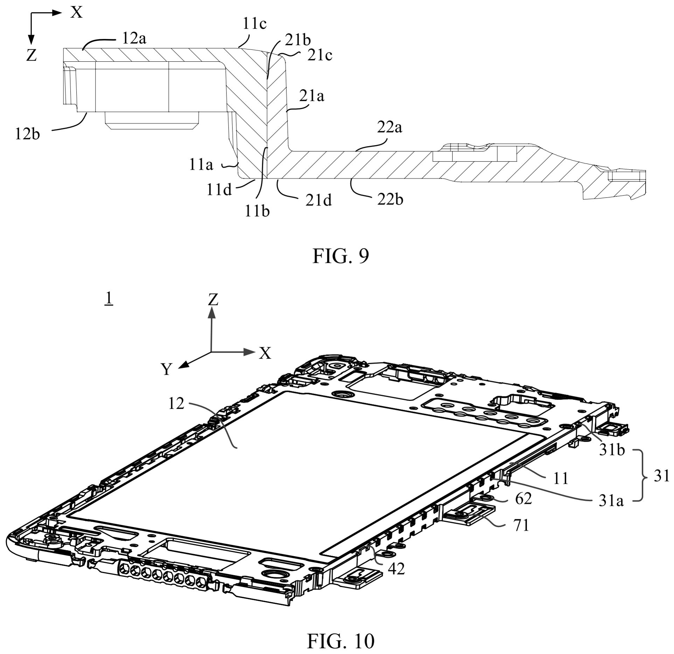

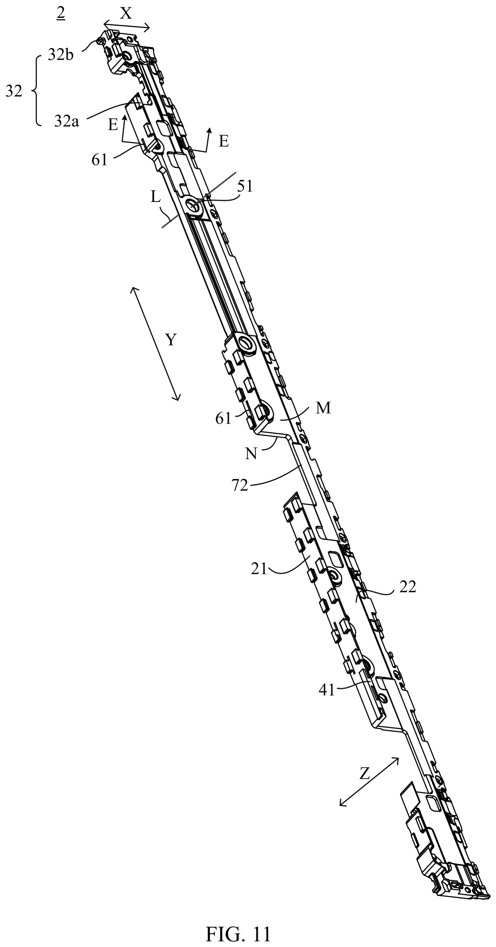

Refer to FIG. 8A to FIG. 11. FIG. 8A is a diagram of a front view structure of a housing of a foldable electronic device according to an embodiment of this application. FIG. 8B is a diagram of a rear view structure of a housing of a foldable electronic device according to an embodiment of this application. FIG. 9 is a cutaway diagram along an I-I direction in FIG. 8A. FIG. 10 is a diagram of a structure of a first middle plate in a housing of a foldable electronic device according to an embodiment of this application. FIG. 11 is a diagram of a structure of a second middle plate in a housing of a foldable electronic device according to an embodiment of this application.

As shown in FIG. 8A to FIG. 11, for ease of understanding, a thickness direction Z of the middle plate, a length direction Y of the middle plate, and a width direction X of the middle plate are shown in the figures. The thickness direction Z of the middle plate may be the thickness direction of the foldable electronic device; the length direction Y of the middle plate may be a length direction of the foldable electronic device, for example, an extension direction of a hinge in the hinge mechanism; and the width direction X of the middle plate may be a width direction of the foldable electronic device. The thickness direction Z of the middle plate, the length direction Y of the middle plate, and the width direction X of the middle plate are perpendicular to each other.

In an implementation, the first middle plate 1 includes a first side wall 11 and a first support plate 12, and the second middle plate 2 includes a second side wall 21 and a second support plate 22. The first support plate 12 has a first surface 12a and a second surface 12b that are disposed opposite to each other along the thickness direction Z of the middle plate, and the first side wall 11 is connected to a side edge of the first support plate 12 and protrudes from the second surface 12b of the first support plate 12.

The first side wall 11 has an inner wall surface 11a facing the first support plate 12 and an outer wall surface 11b facing away from the first support plate 12 that are disposed opposite to each other, and an upper surface 11c and a lower surface 11d that are connected to the inner wall surface 11a and the outer wall surface 11b. The upper surface 11c and the lower surface 11b are disposed opposite to each other along the thickness direction Z of the middle plate. At a joint between the first side wall 11 and the first support plate 12, the upper surface 11c of the first side wall 11 and the first surface 12a of the first support plate 12 are in a same horizontal plane, that is, the upper surface 11c of the first side wall 11 is flush with the first surface 12a of the first support plate 12.

Further, the second support plate 22 has a first surface 22a and a second surface 22b that are disposed opposite to each other along the thickness direction Z of the middle plate, and the second side wall 21 is connected to a side edge of the second support plate 22 and protrudes from the first surface 22a of the second support plate 22. The second side wall 21 has an inner wall surface 21a facing the second support plate 22 and an outer wall surface 21b facing away from the second support plate 22 that are disposed opposite to each other, and an upper surface 21c and a lower surface 21d that are connected to the inner wall surface 21a and the outer wall surface 21b. The upper surface 21c and the lower surface 21d are disposed opposite to each other along the thickness direction Z. At a joint between the second side wall 21 and the second support plate 22, the lower surface 21d of the second side wall 21 and the second surface 22b of the second support plate 22 are in a same horizontal plane, that is, the lower surface 21d of the second side wall 21 is flush with the second surface 22b of the second support plate 22.

Further, the first side wall 11 is connected to the second side wall 21, the second support plate 22 is located on an outer side of the side edge of the first support plate 12 and is spaced apart from the first support plate 12 along the thickness direction Z, a surface that is of the first support plate 12 and that faces the second support plate 22 is the second surface 12b of the first support plate 12, and a surface that is of the second support plate 22 and that faces the first support plate 12 is the first surface 22a of the second support plate 22. The first support plate 12 integrally forms the entirety of the non-hinge accommodating region B, and the second support plate 22, the second side wall 21, and the first side wall 11 collectively form at least a portion of the hinge accommodating region A. The second support plate 22 forms a base plate of the hinge accommodating region A, and the entire second side wall 21 and a portion of the first side wall 11 jointly form a side wall of the hinge accommodating region A, and together with the second support plate 22, enclose a space for accommodating the hinge mechanism 20.

In this structure, the first support plate 12 and the second support plate 22 are separated by the side wall of the hinge accommodating region A, and the hinge mechanism 20 of the foldable electronic device 100 is in contact with only the side wall and a bottom wall of the hinge accommodating region A, and is not in contact with the first support plate 12. This prevents galvanic corrosion between the hinge mechanism 20 and the first support plate 12, prevents a risk that the first support plate 12 cannot support and protect an internal component after being corroded, and avoids a problem of screen failure caused by accumulation of corrosion products. The side wall of the hinge accommodating region A includes the first side wall 11 and the second side wall 21. The first middle plate 1 and the second middle plate 2 are securely combined by using a connection structure between the first side wall 11 and the second side wall 21, to prevent relative movement. In addition, a contact area between the hinge mechanism 20 and the first side wall 11 is reduced, and a tendency for galvanic corrosion to occur between the first side wall 11 and the hinge mechanism 20 is reduced, thereby reducing a risk of hinge jamming. In some alternative implementations, due to limitations such as a mounting space or an internal structure, the side wall of the hinge accommodating region A may alternatively include only the entire second side wall 21. This is not limited in this application.

In an implementation, a limiting structure is disposed at a position at which the first side wall 11 is connected to the second side wall 21, and the limiting structure is configured to make the first middle plate 1 and the second middle plate 2 relatively fastened, so that the first middle plate 1 is connected and fastened to the second middle plate 2, and relative movement between the first middle plate 1 and the second middle plate 2 is limited. A specific structure and a limiting manner of the limiting structure are not limited in this application. The following describes an example of a possible structure of the limiting structure with reference to accompanying drawings.

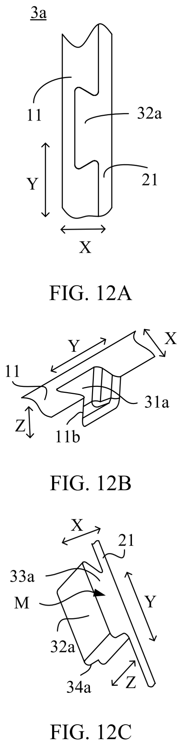

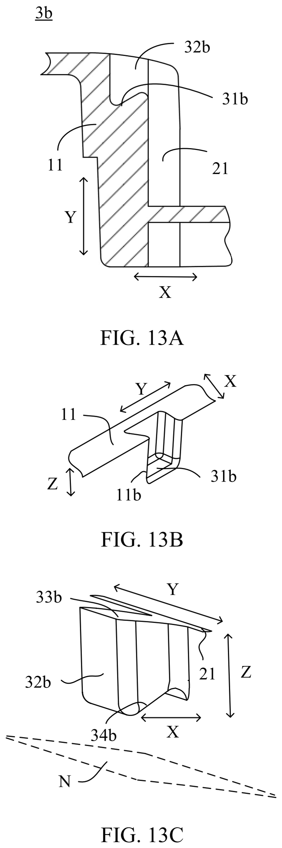

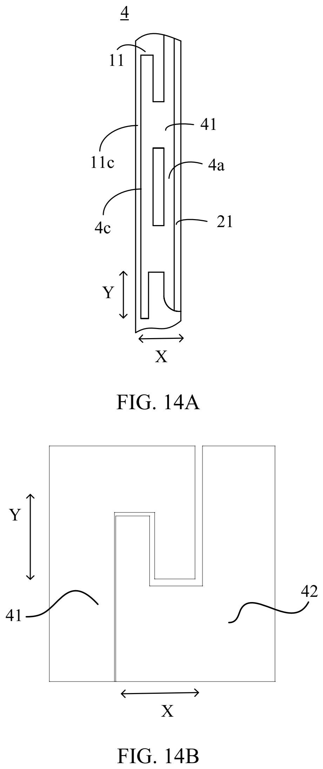

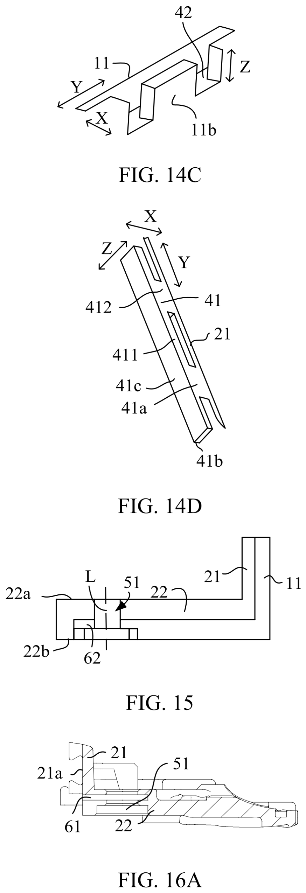

Refer to FIG. 12A to FIG. 14D. FIG. 12A to FIG. 12C are diagrams of a dovetail groove structure in a housing of a foldable electronic device according to an embodiment of this application. FIG. 13A to FIG. 13C are diagrams of an undercut structure in a housing of a foldable electronic device according to an embodiment of this application. FIG. 14A to FIG. 14D are diagrams of a snap-fit structure in a housing of a foldable electronic device according to an embodiment of this application.

As shown in FIG. 10, FIG. 11, and FIG. 12A to FIG. 14D, in an implementation, the limiting structure includes at least one snap-on structure 3, and the first middle plate 1 and the second middle plate 2 are connected by using the snap-on structure 3. Further, each snap-on structure 3 includes a snap groove 31 and a boss 32 that is snapped into the snap groove. The boss 32 is snapped into the snap groove 31, thereby limiting relative movement between the first middle plate 1 and the second middle plate 2. It should be noted that a specific quantity of snap-on structures 3 is not limited. For example, one, two, or more snap-on structures may be disposed.

In an implementation, a plurality of snap-on structures 3 are disposed between the first middle plate 1 and the second middle plate 2. Use of the plurality of snap-on structures 3 reduces a risk that failure of a snap-on structure 3 causes the first middle plate 1 to separate from the second middle plate 2, thereby improving combination reliability.

It should be noted that an arrangement manner of the plurality of snap-on structures 3 is not limited in this application. In an implementation, the plurality of snap-on structures 3 form at least one column of snap-on structures 3, and each column of snap-on structures 3 includes at least two snap-on structures 3 spaced apart along the length direction Y of the middle plate. This arrangement manner is convenient for processing and manufacturing, and can ensure that a joint surface between the first side wall 11 and the second side wall 21 is under uniform stress along the length direction, thereby preventing local deformation and improving connection strength. In an implementation, the plurality of snap-on structures 3 form two columns of snap-on structures, and the two columns of snap-on structures 3 are spaced apart along the thickness direction Z of the middle plate. It may be understood that each snap groove 31 does not penetrate the first side wall 11 along the thickness direction Z of the middle plate. Therefore, relative movement between the first middle plate 1 and the second middle plate 2 along the thickness direction Z of the middle plate may be limited. In addition, the two columns of snap-on structures 3 make the combination tighter, and a surface of the electronic device flatter, thereby improving use experience of a consumer.

It should be noted that positions of the two columns of snap-on structures 3 are not limited. In an implementation, one column of snap-on structures 3 in the two columns of snap-on structures 3 is disposed on a top surface of the side wall of the hinge accommodating region A, the other column of snap-on structures 3 is disposed on a bottom surface of the side wall of the hinge accommodating region A, the top surface of the side wall of the hinge accommodating region A is connected to the first surface 12a of the first support plate 12, and the bottom surface of the side wall of the hinge accommodating region A is connected to the second surface 22b of the second support plate 22. With reference to a structure of each snap-on structure 3 for understanding, the boss 32 has a first end surface 33 and a second end surface 34 that are disposed opposite to each other along the thickness direction Z of the middle plate, the first end surface 33 faces away from the second support plate 22, and the second end surface 34 faces the second support plate 22. First end surfaces 33 of bosses 32 in one column of snap-on structures 3 and the first surface 12a of the first support plate 12 are in a same horizontal plane, and second end surfaces 34 of bosses 32 in the other column of snap-on structures 3 and the second surface 22b of the second support plate 22 are in a same horizontal plane. This makes a surface of the middle plate flatter, and facilitates processing.

A person skilled in the art may understand that specific positions of the snap groove 31 and the boss 32 in each snap-on structure 3 are not limited. One of the snap groove 31 and the boss 32 may be located on the first side wall 11, and the other is located on the second side wall 21. In an implementation, the snap groove 31 is located on the first side wall 11, and the boss 32 is located on the second side wall 21. The snap groove 31 is formed by being recessed toward an interior of the first side wall 11 from the outer wall surface 11b that is of the first side wall 11 and that faces away from the first support plate 12, and the boss 32 is formed by extending outward toward the first support plate 12 from the outer wall surface 21b that is of the second side wall 21 and that faces away from the second support plate 22. When there is a tendency for the first middle plate 1 and the second middle plate 2 to separate from each other, the snap groove 31 and the boss 32 may abut against each other, so that relative movement between the first middle plate 1 and the second middle plate 2 along the length direction Y of the middle plate is limited, and movement of the second middle plate 2 along the width direction X of the middle plate toward a direction of the first middle plate 1 may also be limited, thereby preventing the first middle plate 1 and the second middle plate 2 from separating from each other.

A person skilled in the art may understand that a specific shape of the snap-on structure 3 is not limited.

As shown in FIG. 12A to FIG. 12C, in an implementation, at least some snap-on structures 3 are disposed as dovetail groove structures 3a. A specific quantity of dovetail groove structures 3a is not limited, for example, 8, 10, or 12. In each dovetail groove structure 3a, the snap groove 31 is disposed as a dovetail groove 31a, a groove opening and a groove bottom of the dovetail groove 31a are disposed opposite to each other along the width direction X of the middle plate, two side surfaces connected to the groove opening and the groove bottom are disposed opposite to each other along the length direction Y of the middle plate, and a groove width of the dovetail groove 31a gradually increases from the groove opening to the groove bottom. A boss 32a is disposed as a structure that matches the dovetail groove 31a. The dovetail groove 31a reduces a width of an opening of the snap groove 31, and in addition to serving as the snap groove 31, may limit movement of the second middle plate 2 along the width direction X of the middle plate away from the first middle plate 1, thereby improving stability between the first middle plate 1 and the second middle plate 2.

In an implementation, the boss 32a has a first end surface 33a and a second end surface 34a that are disposed opposite to each other along the thickness direction Z, and the second end surface 34a faces the second support plate 22. In at least some dovetail groove structures 3a, the first end surface 33a and/or the second end surface 34a are/is configured as an inclined surface relative to a first plane M, and a surface that is of the dovetail groove 31a and that is disposed opposite to the inclined surface of the boss 32a is configured as a matching inclined surface. The first plane M is perpendicular to the thickness direction Z of the middle plate.

As shown in FIG. 13A to FIG. 13C, in an implementation, at least some snap-on structures 3 are disposed as undercut structures 3b. In each undercut structure 3b, a boss 32b has a first end surface 33b and a second end surface 34b that are disposed opposite to each other along the thickness direction Z of the middle plate, and the second end surface 34b faces the second support plate 22. Any one or more of the first end surface 33b and the second end surface 34b are configured as inclined surfaces relative to a second plane N, and a surface that is of a snap groove 31b and that is disposed opposite to the inclined surface of the boss 32b is configured as a matching inclined surface. The second plane N is perpendicular to the thickness direction Z of the middle plate.

In the foregoing structure, when there is a tendency for the second middle plate 2 to separate outward from the first middle plate 1, a reaction force provided by each matching inclined surface that is of the snap groove 31 and that is inclined relative to the first plane M or the second plane N may be decomposed into a force along the thickness direction Z of the middle plate and a force along the width direction X of the middle plate, and the force along the width direction X of the middle plate may prevent the second middle plate 2 from separating outward from the first middle plate 1.

A person skilled in the art may understand that the dovetail groove structure 3a and the undercut structure 3b may be freely combined. That is, the snap-on 3 may include neither the dovetail groove structure 3a nor the undercut structure 3b, may include only the dovetail groove structure 3a or only the undercut structure 3b, or may include both the dovetail groove structure 3a and the undercut structure 3b. This is not limited in this application. In an implementation, both the dovetail groove structure and the undercut structure are disposed. Specifically, each column of snap-on structures includes a total of 13 snap-on structures 3 spaced apart, including 12 dovetail groove structures 3a and three undercut structures 3b.

As shown in FIG. 14A to FIG. 14D, in an implementation, the limiting structure includes at least one snap-fit structure 4, and each snap-fit structure 4 includes a snap-fit structure body 41 and a snap-fit groove 42 that are interlocked with each other. The snap-fit structure body 41 and the snap-fit groove 42 are interlocked with each other, to limit the first middle plate 1 and the second middle plate 2. A specific quantity of snap-fit structures 4 is not limited, for example, 1, 2, or 4. In an implementation, one snap-fit structure 4 is disposed.

A person skilled in the art may understand that positions of the snap-fit structure body 41 and the snap-fit groove 42 in the snap-fit structure 4 are not limited. One of the snap-fit structure body 41 and the snap-fit groove 42 may be located on the first middle plate 1, and the other may be located on the second middle plate 2. In an implementation, the snap-fit structure body 41 is located on the second middle plate 2, and the snap-fit groove 42 is located on the first middle plate 1. Specifically, the snap-fit structure body 41 is formed by extending outward from a side surface that is of the second side wall 21 and that faces away from the second support plate 22, and includes a cantilever 411 and two connecting arms 412 spaced apart along a length direction of the cantilever 411; and the cantilever 411 is disposed opposite to and spaced apart from the second side wall 21, one end of each connecting arm 412 in the two connecting arms 412 is connected to the cantilever 411, the other end of each connecting arm 412 is connected to the second side wall 21, and the snap-fit groove 42 is formed in the first side wall 11 by being recessed toward the inner wall surface 11a from the outer wall surface 11b, and configured as a groove structure that matches a shape of the snap-fit structure body 41.

The snap-fit structure 4 may limit relative movement that is of the second middle plate 2 in various directions and that is relative to the first middle plate 1. Specifically, the snap-fit structure body 41 has a top surface 41a and a bottom surface 41b that are disposed opposite to each other along the thickness direction Z of the middle plate, and a side surface 41c that is connected to the top surface 41a and the bottom surface 41b and that faces away from the second side wall 21. After assembly, the top surface 41a of the snap-fit structure body 4 and the upper surface 11c of the first support plate 12 are in a same plane, and the bottom surface 41b and the side surface 41c of the snap-fit structure body 41 abut against the snap-fit groove 42, thereby limiting relative movement that is of the second middle plate 2 toward the second support plate 22 along the thickness direction Z of the middle plate and that is relative to the first middle plate 1, and movement that is of the second middle plate 2 toward the first side wall 11 along the width direction X of the middle plate and that is relative to the first middle plate 1. A protruding portion of the snap-fit groove 42 extends into a gap between the two connecting arms 412, thereby limiting relative movement between the first middle plate 1 and the second middle plate 2 along the width direction X of the middle plate.

The first middle plate 1 and the second middle plate 2 form a structural connection relationship by using the snap-on structure 3 and the snap-fit structure 4 on the first side wall 11 and the second side wall 21, so that the first middle plate 1 and the second middle plate 2 do not move relative to each other in various directions.

A person skilled in the art may understand that the hinge mechanism 20 is fastened to the hinge accommodating region A on the middle plate 110. A fastening structure mated with the hinge mechanism 20 is disposed on the middle plate 110 to fulfill a connection function between the hinge mechanism 20 and the middle plate 110, and a connection structure may be designed to implement performance such as sealing, waterproofing, corrosion resistance, and an electrical connection. This is not limited in this application. The following describes an example of a possible connection manner between the middle plate 110 and the hinge mechanism 20 with reference to accompanying drawings.

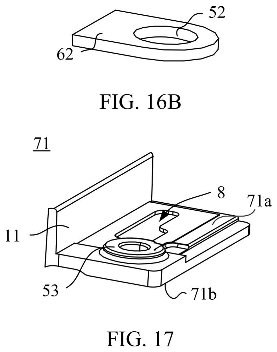

Refer to FIG. 15 to FIG. 17. FIG. 15 is a diagram of a principle of a connection between a housing and a hinge mechanism of a foldable electronic device according to an embodiment of this application. FIG. 16A is a diagram of a cross-sectional structure along an E-E direction in FIG. 10. FIG. 16B is a diagram of a structure of a reinforcing plate of a first middle plate in a housing of a foldable electronic device according to an embodiment of this application. FIG. 17 is a diagram of a structure of an extension portion of a first middle plate in a housing of a foldable electronic device according to an embodiment of this application.

As shown in FIG. 15 to FIG. 17, in an embodiment, the second support plate 22 is provided with a plurality of mounting holes 51, and a fastener such as a screw is disposed through each mounting hole 5, so that the hinge mechanism 20 may be fastened and detachably connected to the second support plate 22. A specific quantity of mounting holes 5 is not limited, and may be 6, 8, 10, or the like. This is not limited in this application. In an implementation, the quantity of mounting holes is 9. In addition, an arrangement manner of the plurality of mounting holes 51 is not limited. In an implementation, the mounting holes 51 are spaced apart along the length direction Y of the middle plate. Due to a space limitation, axes L of the mounting holes 5 are not in a same plane, or it may be understood that vertical distances between the axes L of the mounting holes and the second side wall 21 are different.

As shown in FIG. 10, FIG. 11, FIG. 16A, and FIG. 16B, in an embodiment, the second middle plate 2 is provided with accommodating spaces 61 at positions corresponding to at least some mounting holes 51, and each accommodating space 61 is formed by being recessed toward an interior of the second support plate 22 along the width direction X of the middle plate from a side surface that is of the second side wall 21 and that faces the first side wall 11, and communicates with a corresponding mounting hole 51. The accommodating space 61 is configured to accommodate a reinforcing plate 62 on the first middle plate 1. In an implementation, along the thickness direction Z of the middle plate, the accommodating space 61 is located between the first surface 22a and the second surface 22b of the second support plate 22; and along the width direction X of the middle plate, the accommodating space 61 penetrates the second side wall 21, but does not extend to a side surface that is of the second support plate 22 and that faces away from the second side wall 21.

In an implementation, a protruding reinforcing plate 62 corresponding to the accommodating space 61 is disposed on a side surface that is of the first side wall 11 and that faces the second side wall 21, the reinforcing plate 62 extends into the corresponding accommodating space 61 and is provided with a connection hole 52 aligned with the corresponding mounting hole 5, and the fastener is disposed through the connection hole 52 in the reinforcing plate 62 and the corresponding mounting hole 51, so that the second support plate 22 and the reinforcing plate 62 may be fastened and detachably connected to the hinge mechanism 20. In an implementation, at the accommodating space 61, the reinforcing plate 62 is fully embedded in the second support plate 22 when viewed along the thickness direction Z of the middle plate, and the second support plate 22 covers both upper and lower sides of the reinforcing plate 62, and is securely fastened by using the fastener. Based on the limiting structure on the first side wall 11 and the second side wall 21, a joint position between the first middle plate 1 and the second middle plate 2 is increased, thereby further improving connection strength between the first middle plate 1 and the second middle plate 2.

As shown in FIG. 8A to FIG. 10 and FIG. 17, in an implementation, the first middle plate 1 further includes at least one extension portion 71. A specific quantity of extension portions 71 is not limited, and may be 2, 3, 4, or the like. This is not limited in this application. In an implementation, the quantity of extension portions 71 is 3. Each extension portion 71 extends toward a direction of the second support plate 22 from a side surface that is of the first side wall 11 and that faces away from the first support plate 12. The second middle plate 2 is provided with a notch 72 at a position corresponding to each extension portion 71, and the extension portion 71 is located in the notch 72. The extension portion 71 has a first surface 71a and a second surface 71b that are disposed opposite to each other along the thickness direction Z of the middle plate, the first surface 71a of the extension portion 71 is connected to the first surface 22a of the second support plate 22, the second surface 71b of the extension portion 71 is connected to the second surface 22b of the second support plate 22, and the extension portion 71 and the second support plate 22 jointly form the base plate of the hinge accommodating region A. The extension portion 71 may be configured to implement an electrical connection between the first middle plate 1 and the hinge mechanism 20, for example, ground the hinge mechanism 20.

In an embodiment, each extension portion 71 is provided with a fastening hole 53 and a spring plate mounting groove 8. The fastening hole 53 is a through hole. A fastener is disposed through the fastening hole 53, so that the extension portion 71 may be fastened and detachably connected to the hinge mechanism 20. A region on an outer peripheral side of the fastening hole 53 is attached with an annular insulating film surrounding the fastening hole 53, and the insulating film is not electrically conductive, to prevent galvanic corrosion in the covered region. A spring plate is mounted in the spring plate mounting groove 8, and the spring plate abuts against the hinge mechanism 20, to implement an electrical connection between the first middle plate and the hinge mechanism. Annular foam surrounding the spring plate is disposed on an inner wall surface of the spring plate mounting groove. The annular foam implements a waterproofing function, to prevent galvanic corrosion by preventing electrolytes from entering the spring plate mounting groove.

As shown in FIG. 8A and FIG. 8B, in an embodiment, an avoidance space 9 for a signal line to pass through is provided between the first middle plate 1 and the second middle plate 2, and the avoidance space 9 is configured to mount a part such as the signal line, to connect the first portion 301 and the second portion 302 of the screen 30.

In conclusion, material selection for the housing 10x provided in this application is more flexible. This can maintain stable chemical performance when implementing reduction of a body weight, thereby improving use experience of a consumer.

Finally, it should be noted that the foregoing descriptions are merely specific implementations of this application, but are not intended to limit the protection scope of this application. Any variation or replacement within the technical scope disclosed in this application shall fall within the protection scope of this application. Therefore, the protection scope of this application shall be subject to the protection scope of the claims.

## Claims

1. A housing for a foldable electronic device, comprising a middle plate, wherein the middle plate has a hinge accommodating region and a non-hinge accommodating region, and the hinge accommodating region is configured to accommodate and mount a hinge mechanism of the foldable electronic device, wherein
the middle plate comprises a first middle plate and a second middle plate that are connected to each other, at least a portion of the first middle plate forms at least a portion of the non-hinge accommodating region, at least a portion of the second middle plate forms at least a portion of the hinge accommodating region, and a material of the first middle plate is different from a material of the second middle plate.

2. The housing according to claim 1, wherein a portion of the first middle plate forms the entirety of the non-hinge accommodating region, and the other portion of the first middle plate and the entire second middle plate jointly form the entirety of the hinge accommodating region; or
the entire first middle plate forms the entirety of the non-hinge accommodating region, and the entire second middle plate forms the entirety of the hinge accommodating region.

3. The housing according to claim 1 or 2, wherein
the first middle plate comprises a first support plate and a first side wall, the first support plate has a first surface and a second surface that are disposed opposite to each other along a thickness direction of the first support plate, and the first side wall is connected to a side edge of the first support plate and protrudes from the second surface of the first support plate;
the second middle plate comprises a second support plate and a second side wall, the second support plate has a first surface and a second surface that are disposed opposite to each other along a thickness direction of the second support plate, and the second side wall is connected to a side edge of the second support plate and protrudes from the first surface of the second support plate;
the second side wall is connected to the first side wall, the second support plate is located on an outer side of the side edge of the first support plate and is spaced apart from the first support plate along a thickness direction of the middle plate, and a surface that is of the second support plate and that faces the first support plate is the first surface of the second support plate; and
the first support plate integrally forms the entirety of the non-hinge accommodating region, and the second support plate, the second side wall, and the first side wall collectively form at least a portion of the hinge accommodating region, wherein the second support plate forms a base plate of the hinge accommodating region, and the first side wall and the second side wall jointly form a side wall of the hinge accommodating region, and together with the second support plate, enclose a space for accommodating the hinge mechanism.

4. The housing according to claim 3, wherein a limiting structure is disposed at a position at which the second side wall is connected to the first side wall, and the limiting structure is configured to make the first middle plate and the second middle plate relatively fastened.

5. The housing according to claim 4, wherein the limiting structure comprises at least one snap-on structure, each snap-on structure in the at least one snap-on structure comprises a snap groove and a boss that is snapped into the snap groove, one of the snap groove and the boss is located on the first side wall of the middle plate, and the other is located on the second side wall of the middle plate.

6. The housing according to claim 5, wherein in each snap-on structure, the snap groove is formed by being recessed toward an interior of the first side wall from a side surface that is of the first side wall and that faces away from the first support plate, and the boss is formed by extending outward from a side surface that is of the second side wall and that faces away from the second support plate.

7. The housing according to claim 5 or 6, wherein at least a portion of the at least one snap-on structure is disposed as a dovetail groove structure, and in each dovetail groove structure, the snap groove is disposed as a dovetail groove, two side surfaces of the dovetail groove are disposed opposite to each other along a length direction of the middle plate, and a groove width of the dovetail groove gradually increases from a groove opening to a groove bottom; and the boss is disposed as a structure that matches a shape of the dovetail groove, to limit relative movement between the first middle plate and the second middle plate along the length direction and a width direction of the middle plate.

8. The housing according to claim 7, wherein in each dovetail groove structure, the boss has a first end surface and a second end surface that are disposed opposite to each other along the thickness direction of the middle plate, and the second end surface faces the second support plate; and in at least some dovetail groove structures, the first end surface and/or the second end surface are/is configured as an inclined surface relative to a first plane, and a surface that is of the dovetail groove and that is disposed opposite to the inclined surface of the boss is configured as a matching inclined surface, to limit relative movement between the first middle plate and the second middle plate along the width direction of the middle plate, wherein the first plane is perpendicular to the thickness direction of the middle plate.

9. The housing according to any one of claims 5 to 8, wherein at least a portion of the at least one snap-on structure is disposed as an undercut structure, and in each undercut structure, the boss has a first end surface and a second end surface that are disposed opposite to each other along the thickness direction of the middle plate, and the second end surface faces the second support plate; and the first end surface and/or the second end surface are/is configured as an inclined surface relative to a second plane, and a surface that is of the snap groove and that is disposed opposite to the inclined surface of the boss is configured as a matching inclined surface, to limit relative movement between the first middle plate and the second middle plate along the width direction of the middle plate, wherein the second plane is perpendicular to the thickness direction of the middle plate.

10. The housing according to any one of claims 5 to 9, wherein the at least one snap-on structure is a plurality of snap-on structures.

11. The housing according to any one of claims 5 to 10, wherein the plurality of snap-on structures form at least one column of snap-on structures, and each column of snap-on structures in the at least one column of snap-on structures comprises at least two snap-on structures spaced apart along the length direction of the middle plate.

12. The housing according to claim 11, wherein the at least one column of snap-on structures is two columns of snap-on structures, and the two columns of snap-on structures are spaced apart along the thickness direction of the middle plate.

13. The housing according to claim 12, wherein one column of snap-on structures in the two columns of snap-on structures is disposed on a top surface of the side wall of the hinge accommodating region, the other column of snap-on structures is disposed on a bottom surface of the side wall of the hinge accommodating region, the top surface of the side wall of the hinge accommodating region is connected to the first surface of the first support plate, and the bottom surface of the side wall of the hinge accommodating region is connected to the second surface of the second support plate.

14. The housing according to any one of claims 4 to 13, wherein the limiting structure comprises at least one snap-fit structure, and each snap-fit structure in the at least one snap-fit structure comprises a snap-fit structure body and a snap-fit groove that are interlocked with each other; and
the snap-fit structure body is formed by extending outward from a side surface that is of the second side wall and that faces away from the second support plate, and comprises a cantilever and two connecting arms spaced apart along a length direction of the cantilever; and the cantilever is disposed opposite to and spaced apart from the second side wall, one end of each connecting arm in the two connecting arms is connected to the cantilever, the other end of each connecting arm is connected to the second side wall, and the snap-fit groove is formed in the first side wall and configured as a groove structure that matches a shape of the snap-fit structure body.

15. The housing according to any one of claims 3 to 14, wherein the second support plate is provided with a plurality of mounting holes, and a fastener is disposed through each of the plurality of mounting holes, so that the second support plate may be fastened and detachably connected to the hinge mechanism, wherein axes of all of the plurality of mounting holes are not in a same plane.

16. The housing according to claim 15, wherein the second middle plate is provided with accommodating spaces at positions corresponding to at least some of the plurality of mounting holes, and each accommodating space is formed by being recessed toward an interior of the second support plate along the width direction of the middle plate from a side surface that is of the second side wall and that faces the first side wall, and communicates with a corresponding mounting hole; and
a protruding reinforcing plate corresponding to each accommodating space is disposed on a side surface that is of the first side wall and that faces the second side wall, the reinforcing plate extends into the corresponding accommodating space and is provided with a connection hole aligned with the corresponding mounting hole, and the fastener is disposed through each connection hole and the corresponding mounting hole, so that the second support plate and the reinforcing plate may be fastened and detachably connected to the hinge mechanism.

17. The housing according to claim 16, wherein the reinforcing plate is fully embedded in the second support plate.

18. The housing according to any one of claims 3 to 17, wherein the first middle plate further comprises at least one extension portion, and each extension portion in the at least one extension portion extends toward a direction of the second support plate from the side surface that is of the first side wall and that faces away from the first support plate; the second middle plate is provided with a notch at a position corresponding to each extension portion, and the extension portion is located in the notch; and the extension portion has a first surface and a second surface that are disposed opposite to each other along a thickness direction of the extension portion, the first surface of the extension portion is connected to the first surface of the second support plate, the second surface of the extension portion is connected to the second surface of the second support plate, and the at least one extension portion and the second support plate jointly form the base plate of the hinge accommodating region.

19. The housing according to claim 18, wherein each extension portion is provided with a fastening hole and a spring plate, and a fastener is disposed through the fastening hole, so that the extension portion may be fastened and detachably connected to the hinge mechanism; a region on an outer peripheral side of the fastening hole is attached with an annular insulating film surrounding the fastening hole; and the spring plate abuts against the hinge mechanism, the extension portion is provided with a spring plate mounting groove at a position corresponding to the spring plate, the spring plate is mounted in the spring plate mounting groove, and annular foam surrounding the spring plate is disposed on an inner wall surface of the spring plate mounting groove.

20. The housing according to any one of claims 1 to 19, wherein an avoidance space for a signal line to pass through is provided between the first middle plate and the second middle plate.

21. The housing according to any one of claims 1 to 20, wherein the first middle plate is an integral structure made of an alloy material, and the second middle plate is an integral structure made of an alloy material or plastic.

22. The housing according to claim 21, wherein when both the first middle plate and the second middle plate are integral structures made of alloy materials, a density of the first middle plate is less than a density of the second middle plate; and
the hinge mechanism has a mating component in contact with the second middle plate, a material of the mating component is an alloy, and an absolute value of a potential difference between the alloy material of the mating component and an alloy material of the second middle plate is less than an absolute value of a potential difference between the alloy material of the mating component and an alloy material of the first middle plate.

23. The housing according to claim 21 or 22, wherein when both the first middle plate and the second middle plate are integral structures made of alloy materials, a material of the first middle plate is a magnesium alloy, and a material of the second middle plate is an aluminum alloy.

24. A foldable electronic device, comprising a hinge mechanism, and a first housing and a second housing that are disposed on two sides of the hinge mechanism, wherein the first housing and the second housing are rotatably connected by using the hinge mechanism, so that the first housing and the second housing can be relatively expanded or folded; and at least one of the first housing and the second housing uses the housing according to any one of claims 1 to 23.

25. The foldable electronic device according to claim 24, wherein each of the first housing and the second housing uses the housing according to any one of claims 1 to 23.

26. The foldable electronic device according to claim 24 or 25, wherein the hinge mechanism comprises a base, and a first rotating arm and a second rotating arm that are disposed on two sides of the base; one end of the first rotating arm is rotatably connected to one side of the base, and the other end is connected to a hinge accommodating region of a middle plate of the first housing by using a first connecting bracket; and one end of the second rotating arm is rotatably connected to the other side of the base, and the other end is connected to a hinge accommodating region of a middle plate of the second housing by using a second connecting bracket.
